Europäisches Patentamt

European Patent Office

Office européen des brevets

(19)

(11) EP 0 757 234 A1

(12) # DEMANDE DE BREVET EUROPEEN

(43) Date de publication:
05.02.1997 Bulletin 1997/06

(51) Int Cl.⁶: **G01J 5/06**, H01L 31/024

(21) Numéro de dépôt: 96420256.8

(22) Date de dépôt: 25.07.1996

(84) Etats contractants désignés:
**DE GB IT**

(30) Priorité: **02.08.1995 FR 9509631**

(71) Demandeur: **SOCIETE FRANCAISE DE DETECTEURS, INFRAROUGES- SOFRADIR F-92290 Chatenay Malabry (FR)**

(72) Inventeurs:
• **Veyrier, Jacques**
**38120 Saint Egreve (FR)**

• **Magli, Serge**
**38320 Eybens (FR)**

(74) Mandataire: **Vuillermoz, Bruno et al**
**Cabinet Laurent & Charras**
**B.P. 32**
**20, rue Louis Chirpaz**
**69131 Ecully Cédex (FR)**

(54) **Assemblage d'un détecteur à infrarouge avec compensation thermique**

(57)    Ce procédé pour réaliser l'assemblage d'un bloc de détection de rayonnements électro-magnétiques, et notamment infrarouges, constitué par un circuit électronique de détection (8) desdits rayonnements, muni d'un circuit de lecture (7), auquel il est connecté au moyen de microbilles d'indium (9), avec un support (5) conducteur thermique ou plan froid solidarisé à une source froide (4), à l'interface desquels est interposé un élément intermédiaire (11, 14, 16) également bon conducteur thermique, solidarisé respectivement au bloc de détection (7, 8, 9) par collage et au support (5) par collage ou brasure, consiste à conférer au(x) composant (s) dudit élément intermédiaire (11, 14, 16) des dimensions, et notamment une (des) épaisseur(s) fonction de celle du circuit de lecture (7), de telle sorte à compenser les effets inhérents aux phénomènes de dilatation différentielle de chacun des matériaux qui les composent.

FIG.3

## Description

L'invention concerne un procédé d'assemblage d'un bloc de détection d'ondes électromagnétiques, et notamment d'infrarouges, avec un support conducteur thermique. Elle concerne également un détecteur de telles ondes électromagnétiques et notamment un détecteur de rayonnement infrarouge mettant en oeuvre ce procédé.

Par bloc de détection, on entend l'ensemble constitué par d'une part, un circuit électronique de détection d'ondes électromagnétiques proprement dit, transformant de manière connu un rayonnement électromagnétique en un signal électrique, associé à un circuit de lecture, c'est à dire susceptible de transformer les signaux électriques issus du circuit de détection, notamment en les amplifiant pour les rendre susceptibles d'un traitement ultérieur.

Dans le cadre de la détection du rayonnement infrarouge, il est bien connu que le circuit de détection, par exemple constitué de barettes ou matrices de photodiodes, doit fonctionner à basse température, à savoir notamment dans une gamme de température comprise entre 50 et 200 kelvins (K). De fait, ces circuits de détection sont généralement installés au sein d'une enceinte cryostatique (cryostat), dont le doigt froid contient, selon leur température d'utilisation, de l'azote liquide ou de l'air liquide ou tout autre dispositif cryogénérateur.

Suite aux différents perfectionnements des dispositifs détecteurs infrarouges, ceux-ci sont avantageusement hybridés c'est à dire que le circuit détecteur du rayonnement infrarouge proprement dit est couplé au circuit de lecture au moyen de microbilles d'indium, permettant notamment de réduire considérablement l'encombrement généré, et surtout de simplifier au maximum la connectique entre ces différents circuits. Dans ce cas, le circuit de détection doit permettre l'éclairement des photosites par la face arrière. En outre, dans certaines configurations mettant en oeuvre de grands dispositifs complexes, on peut également rencontrer des circuits de détection et de lecture connectés électriquement l'un à l'autre par hybridation à un circuit de connectique commun. Dans un cas comme dans l'autre, la finalité et la mise en oeuvre de l'invention demeurent inchangées. Dans les deux cas, on parle de bloc de détection.

Le bloc de détection ainsi défini est donc en permanence en échange thermique avec le plan froid, c'est à dire l'extrémité du doigt froid du cryostat, assurant en outre la fonction d'étanchéité de ce dernier, ledit bloc de détection, et notamment le circuit de lecture étant maintenu mécaniquement et thermiquement en contact avec le plan froid par l'intermédiaire d'un interface généralement constitué par un support isolant du type céramique, assurant également la fonction de connectique électrique entre le bloc de détection et le cryostat. La liaison entre ce support et le bloc de détection est réalisée au moyen d'un joint de colle, électriquement conductrice ou isolante, et dans le premier cas, constituée par exemple en résine époxyde comportant des charges métalliques, destinées à assurer la conduction électrique entre la face arrière du bloc de détection et plus précisément du circuit de lecture et la connectique de cet interface céramique.

Cette connectique est généralement constituée de pistes métalliques gravées ou sérigraphiées sur ce support intermédiaire en céramique. En outre, ce support céramique est lui-même fixé sur le plan froid du cryostat au moyen d'un joint de colle, typiquement en silicone.

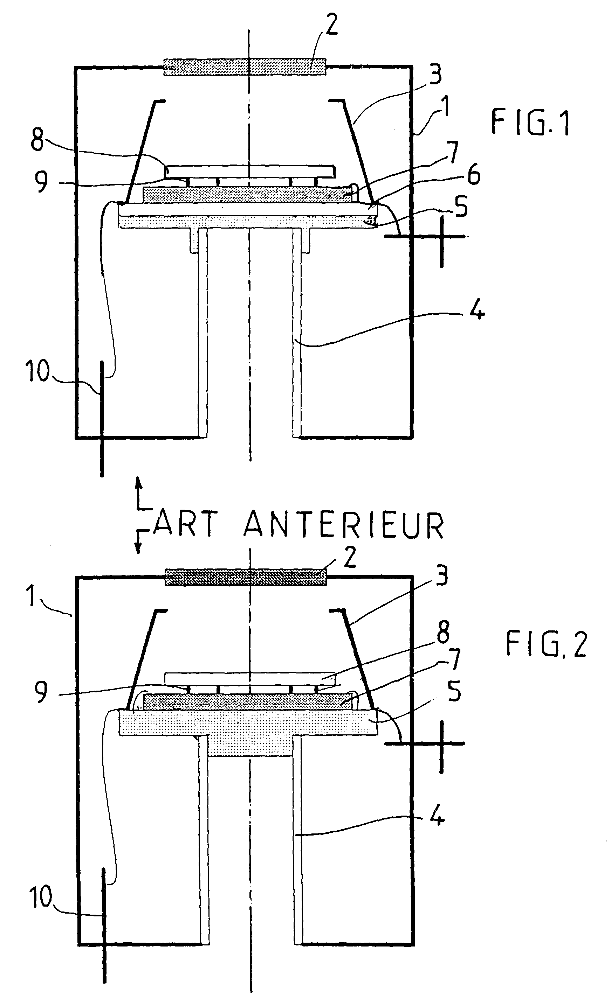

On a représenté sur la figure 1, un exemple illustrant une telle réalisation, constituant l'un des éléments de l'art antérieur. On a représenté par la référence (1) le détecteur infrarouge muni de son système cryogénérateur, et notamment le doigt froid (4). L'entrée de ce détecteur est constitué par un organe filtrant (2), destiné à sélectionner les bandes de longueur d'onde souhaitées, et centré selon l'axe optique dudit détecteur. Dans tous les cas, cette fenêtre (2) assure la fermeture hermétique du cryostat.

Le doigt froid (4) du système cryogénérateur reçoit à son extrémité supérieure un plan froid (5), fixé de manière étanche sur celui-ci et réalisée en un matériau bon conducteur thermique. Associé à ce plan froid (5) est solidarisé par un joint de colle non représenté, généralement en silicone, un support intermédiaire (6), assurant la fonction de support pour le réseau d'interconnexion, généralement réalisé en un matériau céramique, et notamment en alumine, et permettant la liaison électrique entre le circuit de lecture et la connectique de sortie du cryostat.

De fait, le circuit de lecture (7) est fixé sur ce support intermédiaire (6), notamment par collage en résine époxyde, le plus souvent conductrice électriquement, afin d'assurer, quand cela est recherché, la prise de contact électrique avec la face arrière du circuit de lecture. Enfin, le circuit de détection (8) est solidarisé et connecté électriquement au circuit de lecture (7) au moyen de microbilles d'indium (9). L'ensemble circuit de détection (7) - microbilles (9) - circuit de détection (8) est donc en liaison thermique avec le plan froid (5) du cryostat.

Par ailleurs, afin de limiter les rayonnements parasites, on fixe au plan froid (5) ou sur le support intermédiaire (6) un diaphragme (3), donc porté à basse température.

On observe donc que dans les détecteurs de l'art antérieur, le plan froid (5) assure simultanément plusieurs fonctions : Tout d'abord une fonction d'étanchéité, de par l'utilisation d'un scellement hermétique ou brasure entre le doigt froid (4) et le plan froid (5) ; Ensuite, et dans le cas d'un plan froid électriquement isolant, une fonction d'interconnexion par dépôt de conducteurs sur sa face supérieure, ainsi que par exemple décrit dans le document US-A-5 111 050. De fait et dans le cas d'un plan froid métallique, donc électriquement conducteur, celui-ci remplit la fonction de support pour le réseau d'interconnexion, généralement en alumine, qui permet une liaison électrique entre le circuit de lecture et la connectique de sortie du cryostat.

On observe avec de tels détecteurs, qu'au cours de mises en froid successives, les phénomènes de dilatation différentielle se manifestent entre les différents matériaux constituant le plan focal, c'est-à-dire l'ensemble constitué par le bloc de détection, le support intermédiaire et le plan froid. Ces phénomènes engendrent des déformations du plan focal, et en conséquence des efforts et de déformations des microbilles d'indium, et provoquent à la longue leur rupture, inhérente à des phénomènes de fatigue.

Ces ruptures des microbilles d'indium induisent donc une fragilisation de la tenue mécanique du circuit de détection, et surtout une rupture de la continuité des contacts électriques entre ledit circuit de détection et le circuit de lecture, affectant de manière générale la fiabilité du fonctionnement du détecteur, et ses performances.

On a alors proposé pour pallier cet inconvénient, par exemple dans le document US-A-5 111 050 déjà cité, de modifier tout le plan froid du détecteur selon la figure 2. Dans ce cas, on utilise comme plan froid, un matériau mieux adapté en dilatation au circuit de lecture (7), et ce, en l'absence de tout support intermédiaire. Un tel élément (5) est par exemple réalisé en nitrure d'aluminium, le circuit de lecture étant dans ce cas réalisé en silicium. Cependant, on observe que nonobstant l'utilisation d'un tel matériau, les déformations des billes d'indium demeurent, avec à la longue, apparition de leur rupture, en raison d'un écart persistant quoique faible, entre les coefficients de dilatation du plan froid et du circuit de lecture.

L'objet de l'invention est de s'affranchir de ces phénomènes de rupture des microbilles d'indium inhérents aux déformations du plan focal inhérentes à la dilatation différentielle des matériaux constitutifs dudit plan focal.

Selon l'invention, le procédé pour réaliser l'assemblage du bloc de détection, constitué par un circuit électronique de détection de rayonnements électro-magnétiques, et notamment infrarouges, muni d'un circuit de lecture, avec un support conducteur thermique ou plan froid solidarisé à une source froide, à l'interface desquels est interposé un élément intermédiaire également bon conducteur thermique,et solidarisé respectivement au bloc de détection et au plan froid par collage, se caractérise en ce qu'il consiste à conférer au(x) composant(s) dudit élément intermédiaire une (des) dimension (s), et notamment une (des) épaisseur(s) fonction de celle du circuit de lecture, de telle sorte à compenser les effets inhérents aux phénomènes de dilatation différentielle de chacun des matériaux qui les composent.

En d'autres termes, avec l'utilisation d'un tel élément intermédiaire, on aboutit à une compensation des effets de dilatation différentielle entre les différents matériaux constitutifs du plan focal, susceptibles de minimiser voire d'annuler toute déformation des microbilles d'indium.

Ledit élément intermédiaire peut être monobloc, ou pluri-composants.

Dans une première forme de réalisation de l'invention, dans laquelle l'élément intermédiaire est monobloc, ledit élément présente avantageusement un coefficient de dilatation linéaire moyen supérieur à celui du matériau constitutif du circuit de lecture, et également supérieur à celui du matériau constitutif du plan froid, et donc notamment, le plan froid. Il est réalisé dans le groupe comprenant l'alumine polycrystalline, le saphir, le nitrure d'aluminium, etc. .

Le coefficient de dilatation linéaire moyen est défini comme étant égal au rapport de l'intégrale de la variation relative de longueur entre la température ambiante et la température de fonctionnement, par exemple 77 K pour le matériau considéré, sur cet intervalle de température. Ainsi, à 300 K, le coefficient de dilatation linéaire moyen $\alpha_{moyen}$ est défini :

$$\alpha_{moyen} = 1 \; / \; 300 - 77 \; \times \int_{77}^{300} dl/l$$

où l désigne la longueur.

Dans une seconde forme de réalisation de l'invention, dans laquelle l'élément intermédiaire est pluri-composants, et typiquement constitué de deux plaques parallèles, le matériau constitutif de la plaque supérieure, en contact avec le circuit de lecture, présente un coefficient de dilatation linéaire moyen supérieur à celui du matériau constitutif dudit circuit de lecture, et supérieur à celui du matériau constitutif de la seconde plaque de l'élément intermédiaire, c'est à dire de la plaque inférieure au contact avec le plan froid. Le coefficient de dilatation linéaire moyen de ladite seconde plaque est voisin de celui du matériau du circuit de lecture (en général en silicium), et plus précisément compris entre $5 . 10^{-7}$ et $1,8 . 10^{-6} \, K^{-1}$. Le matériau constitutif de cette seconde plaque peut être choisi dans le groupe comprenant le silicium, le carbure de silicium, et le nitrure d'aluminium.

Dans les deux variantes de l'invention ainsi introduites, la plaque de l'élément intermédiaire située sous le circuit de lecture est solidarisée à ce dernier au moyen d'une colle époxyde, éventuellement conductrice électrique, et dont l'autre face reçoit un joint de colle silicone, afin de permettre sa solidarisation à la seconde plaque ou plaque inférieure de l'élément intermédiaire, lorsque ce dernier est pluri-composants, ou au plan froid dans la configuration monobloc. Dans le cas d'une configuration pluri-composants, la plaque inférieure est assujettie au plan froid par tout moyen, collage ou brasure de toute nature, ce mode de solidarisation étant sans incidence pour la mise en oeuvre de l'invention.

L'invention concerne également le détecteur mettant en oeuvre ce procédé. Ce détecteur de rayonnements électro-magnétique, notamment de rayonnement infrarouge, comprend :

- un bloc de détection intégrant :

  . un circuit de détection ;
  . un circuit de lecture connecté électriquement et mécaniquement au moyen de microbilles d'indium audit circuit de détection ;

- un plan froid solidarisé au doigt froid d'un système cryogénérateur;
- un élément intermédiaire, solidarisé par collage au bloc de détection et au plan froid.

Ce détecteur se caractérise en ce que l'élément intermédiaire est monobloc et présente des dimensions, et notamment une épaisseur fonction de celle du circuit de lecture auquel il est solidarisé, de telle sorte à compenser les effets inhérents aux phénomènes de dilatation différentielle de chacun des matériaux qui les composent, ledit élément étant solidarisé au circuit de lecture au moyen d'un joint de colle époxyde, et au plan froid au moyen d'une colle silicone.

Dans une autre forme de réalisation, le détecteur se caractérise en ce que l'élément intermédiaire est pluri-composants, et comporte deux plaques parallèles, respectivement une plaque supérieure, solidarisée au circuit de lecture au moyen d'un joint de colle époxyde, et une plaque inférieure, solidarisée à ladite plaque supérieure au moyen d'un joint de colle silicone, et au plan froid par tout moyen, les matériaux et les épaisseurs desdites plaques étant fonction de celle du circuit de lecture, de telle sorte à compenser les effets inhérents aux phénomènes de dilatation différentielle de chacun des matériaux qui les composent.

La manière dont l'invention peut être réalisée et les avantages qui en découlent ressortiront mieux de l'exemple de réalisation qui suit donné à titre indicatif et non limitatif à l'appui des figures annexées.

Les figures 1 et 2 sont comme déjà dit des représentations schématiques en section d'un détecteur infrarouge associé au doigt froid d'un cryostat selon l'art antérieur.

La figure 3 est une représentation schématique en section d'un détecteur infrarouge conforme à une première forme de réalisation de l'invention.

La figure 4 est une représentation schématique en section d'un détecteur infrarouge conforme à une seconde forme de réalisation de l'invention.

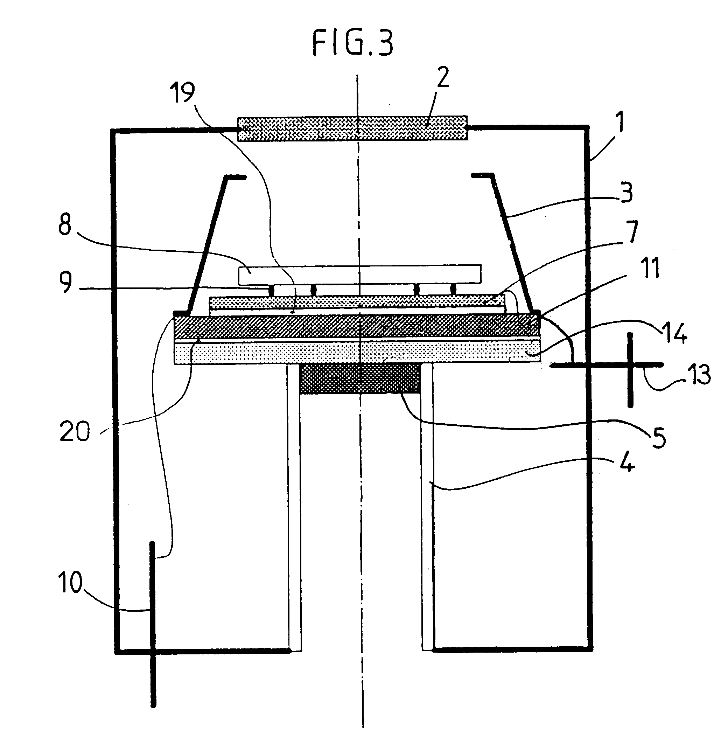

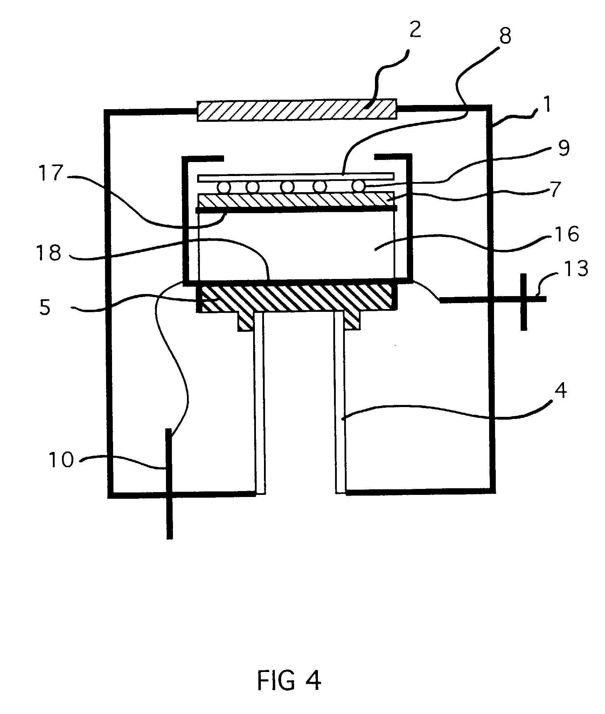

Les éléments fondamentaux des détecteurs infrarouges des figures 3 et 4 conformes à l'invention ont déjà été listés et référencés dans la description des figures 1 et 2 relatives à l'art antérieur.

Fondamentalement, et dans le cadre d'une première forme de réalisation de l'invention représentée en figure 3, dans laquelle l'élément intermédiaire objet de l'invention est pluri-composants, le bloc de détection, constitué par le circuit de détection (8), lui-même constitué de barettes ou matrices de photodiodes, est solidarisé au circuit de lecture (7) au moyen de microbilles d'indium (9), et est lui-même solidarisé à un élément intermédiaire composite, comprenant une plaque (11) réalisée en saphir, liée par collage au moyen d'un joint de colle silicone (20) à une plaque de nitrure d'aluminium (14), la face libre de la plaque en saphir (11), c'est à dire sa face supérieure étant collée au circuit de lecture (7) par un joint de colle époxyde conductrice (19), et la face libre de la plaque en nitrure d'aluminium (14), c'est à dire sa face inférieure, étant collée ou brasée au plan (5), formant bouchon d'étanchéité du doigt froid (4) du cryostat.

Les propriétés diélectriques de la plaque supérieure (11) par exemple réalisé en saphir, constitutive de l'élément intermédiaire, permettent la réalisation d'un réseau d'interconnexion à sa surface, entre le circuit de détection (7) et les entrées et sorties électriques au niveau du cryostat, dont l'une est représentée par la référence (10), et l'autre par la référence (13).

De manière connue, l'élément intermédiaire composite (11, 14) présente une bonne conductibilité thermique afin de favoriser la diffusion du froid du doigt froid, auquel il est solidarisé par collage ou brasure, en direction du bloc de détection.

Dans un exemple de réalisation dans lequel le circuit de détection et de lecture est constitué par une barette linéaire de 288 lignes de quatre diodes hybridée à un circuit de lecture silicium CCD, et dont les dimensions du circuit de lecture (7) sont de 10 x 6 x 0,54 mm. On introduit une structure intermédiaire composite constituée d'une part, par une plaque (11) en saphir, dont les dimensions sont 10 x 11 x 1,27 mm, comportant sur sa face supérieure en contact avec le circuit de lecture un film de colle époxyde (19) chargée en charges métalliques, d'envrion 10 μm d'épaisseur, et d'autre part, par une plaque en nitrure d'aluminium (14), dont les dimensions sont 16 x 11 x 0,6 mm, solidarisée à la plaque saphir (11) par un film de colle silicone (20).

Si les dimensions largeurs et longueurs des plaques constitutives de l'élément intermédiaire composite (11, 14) sont imposées par celles du circuit de lecture (7), en revanche leur épaisseur relève de plusieurs considérations :

- tout d'abord, et s'agissant de la plaque en nitrure d'aluminium (14), à épaisseur de silicium du circuit de lecture donnée, celle de la plaque (14) est au moins égale à 110% de cette épaisseur, et avantageusement limitée au double de celle-ci. Les modélisations montrent en effet, qu'au delà de cette valeur, les gains obtenus sont mineurs, et qu'en outre, compte tenu de la masse alors rajoutée, la structure obtenue n'est plus compatible avec l'application envisagée, particulièrement en termes de résistance aux chocs et vibrations ;
- parallèlement, une fois l'épaisseur de la plaque (14) déterminée, l'épaisseur de la plaque de saphir (11) est obtenue par la méthode des éléments finis appliquée au calcul des dilatations et de déformation du plan focal. Plus précisément, par le biais de cette méthode bien connue, on détermine l'épaisseur minimum de la plaque saphir (11) conduisant à une déformation des microbilles d'indium inférieure à plus ou moins 1%.

Il n'existe donc pas de solution unique, mais la réalisation la plus logique et la plus économique doit aboutir, à résultats identiques, à minimiser les épaisseurs retenues pour des raisons de masses et de transfert thermique.

L'étanchéité entre le plan froid (5) et le doigt froid (4) du cryostat est assurée, au moyen d'une brasure en un scellement hermétique, dont la nature dépend de la technologie utilisée pour assurer la production de froid. Ainsi ce plan froid (5) peut être réalisé en Molybdène, Titane, saphir, verre, Kovar (marque déposée par WESTINGHOUSE - désignant un alliage métallique constitué de 54% de Fer, 29% de Nickel et 17% de Cobalt), voire acier inoxydable.

Dans la seconde forme de réalisation de l'invention, décrite ci-après en liaison avec la figure 4, et dans lequel le bloc de détection est constitué de la même manière que dans l'exemple précédent, on dispose un circuit d'interconnexion (16) en alumine polycrystalline ou saphir, entre ledit bloc de détection et le plan froid (5) d'un cryostat. Cet élément intermédiaire monobloc (16) présente une épaisseur de 2,5 mm, déterminée également par la méthode des éléments finis. Cet élément (16) comporte sur sa face supérieure au contact du circuit de lecture (7) un film de colle époxyde (17), éventuellement chargée en charges métalliques, et destiné à assurer la solidarisation dudit circuit de lecture (7) sur l'élément intermédiaire (16), et sur sa face inférieure en contact avec le plan froid (5), un film de colle silicone (18), également pour assurer sa solidarisation avec ledit plan froid.

La mise en oeuvre d'un tel élément intermédiaire de 2,5 mm d'épaisseur, en lieu et place des éléments intermédiaires de l'art antérieur d'épaisseur typique de 0,635 mm, telles que par exemple distribués par la société MIC TECHNOLOGIE, permet d'aboutir, à une mise en oeuvre plus simple que celle de l'exemple précédemment décrit, mais en revanche, à des résultats légèrement moins bons que celui-ci, puisque l'allongement des microbilles d'indium les plus sollicitées atteint 5%. Cependant, ce résultat est à comparer aux allongements desdites microbilles d'indium dans le cadre des réalisations standards de l'art antérieur, mettant par exemple en oeuvre une plaque d'alumine de 0,635 mm d'épaisseur, et pour lesquelles l'allongement des microbilles est voisin de 20% (ces résultats s'entendent d'un calcul appliqué à une réalisation mettant en oeuvre des microbilles d'indium d'un diamètre d'environ 30 μm).

On observe donc, que lors des variations thermiques, la déformation des microbilles d'indium est réduite à néant, selon la direction parallèle à l'axe perpendiculaire aux composants, c'est à dire selon l'axe optique du détecteur, et insignifiante et typiquement inférieure au micromètre dans le plan dudit composant, c'est à dire dans le plan perpendiculaire de l'axe optique du détecteur.

La mise en oeuvre de l'invention conduit donc à dissocier les fonctions d'étanchéité du plan froid, et d'interconnexion du plan focal à l'inverse des enseignements de l'art antérieur, et notamment du document US-A-5 111 050.

On a donc ainsi pu aboutir à la réduction voire à l'annulation des déformations des microbilles d'indium inhérentes aux dilatations différentielles, et partant à assurer une fiabilité et une résistance accrues des détecteurs ainsi réalisés.

L'invention permet donc d'aboutir aux avantages suivants :

Tout d'abord, elle permet de définir des plans focaux adaptés à n'importe quel type de cryostat, que celui-ci relève de la technologie métal ou de la technologie verre.

Elle permet ensuite d'utiliser aussi bien les détecteurs montés dans des cryostat classiques refroidis par détente JOULE-THOMSON ou machines STIRLING qu'avec des détecteurs utilisés avec des machines STIRLING intégrées, dans lesquelles le détecteur est directement monté sur le doigt froid de ladite machine.

De plus, l'élément intermédiaire mis en oeuvre est indépendant de la connectique de sortie du cryostat. En d'autres termes, on peut utiliser aussi bien un cryostat mettant en oeuvre des lignes souples que les sorties directes par fils, ou des conducteurs gravés sur le doigt froid du cryostat en verre, par exemple par sérigraphie.

Enfin, l'invention permet d'adapter à la géométrie du détecteur l'élément intermédiaire qui permet donc de traiter aussi bien les barrettes linéaires que les matrices de détection.

## Revendications

1. Procédé pour réaliser l'assemblage d'un bloc de détection de rayonnements électro-magnétiques, et notamment infrarouges, constitué par un circuit électronique de détection (8) desdits rayonnements, muni d'un circuit de lecture (7), auquel il est connecté au moyen de microbilles d'indium (9), avec un support (5) conducteur thermique ou plan froid solidarisé à une source froide (4), à l'interface desquels est interposé un élément intermédiaire (11, 14, 16) également bon conducteur thermique, solidarisé respectivement au bloc de détection (7, 8, 9) par collage et au support (5) par collage ou brasure, *caractérisé* en ce qu'il consiste à conférer au(x) composant(s) dudit élément intermédiaire (11, 14, 16) des dimensions, et notamment une (des) épaisseur(s) fonction de celle du circuit de lecture (7), de telle sorte à compenser les effets inhérents aux phénomènes de dilatation différentielle de chacun des matériaux qui les composent.

2. Procédé d'assemblage selon la revendication 1, *caractérisé* en ce que l'élément intermédiaire (16) est monobloc.

3. Procédé d'assemblage selon la revendication 1, *caractérisé* en ce que l'élément intermédiaire (11, 14) est pluri-composants, et est constitué de deux plaques parallèles, respectivement une première plaque (11), solidarisée mécaniquement par collage en résine époxyde au circuit de lecture (7) et éventuellement connecté électriquement à celui-ci, et une seconde plaque (14), solidarisée mécaniquement au plan froid (5), lesdites plaques (11, 14) étant solidarisées entre elles par collage au moyen d'un joint de colle silicone.

4. Procédé d'assemblage selon l'une des revendications 1 à 3, *caractérisé* en ce que l'élément intermédiaire (11, 14, 16) est réalisé en un matériau présentant un coefficient de dilatation linéaire moyen, défini comme étant égal au rapport de l'intégrale de la variation relative de sa longueur entre la température ambiante et la température de fonctionnement pour le matériau considéré sur cet intervalle de température, supérieur à celui du matériau constitutif du circuit de lecture (7), et supérieur à celui du matériau constitutif du plan froid (5).

5. Procédé d'assemblage selon l'une des revendications 1 à 4, *caractérisé* en ce que l'élément intermédiaire (11, 14, 16) est réalisé en un matériau choisi dans le groupe comprenant l'alumine polycrystalline, le saphir, le nitrure d'aluminium, le silicium passivé, le carbure de silicium.

6. Détecteur de rayonnements électro-magnétiques, et notamment infrarouges, comprenant :

   - un bloc de détection intégrant au sein d'une enceinte cryostatique :

     . un circuit de détection (8) desdits rayonnements ;
     . un circuit de lecture (7), connecté électriquement et mécaniquement au moyen de microbilles d'indium (9) audit circuit de détection (8) ;

   - un plan froid (5) solidarisé au doigt froid (4) d'un système cryogénérateur,
   - un élément intermédiaire (16) solidarisé par collage au bloc de détection (7,8, 9) et au plan froid (5),

*caractérisé* en ce que l'élément intermédiaire (16) est monobloc et présente des dimensions, et notamment une épaisseur fonction de celle du circuit de lecture (7) auquel il est solidarisé, de telle sorte à compenser les effets inhérents aux phénomènes de dilatation différentielle de chacun des matériaux qui les composent, ledit élément (16) étant solidarisé au circuit de lecture (7) au moyen d'un joint de colle époxyde (17), et au plan froid (5) au moyen d'un joint de colle silicone (18).

7. Détecteur de rayonnements électro-magnétiques, et notamment infrarouges selon la revendication 6, *caractérisé* en ce que l'élément intermédiaire (16) est réalisé en un matériau présentant un coefficient de dilatation linéaire moyen, défini comme étant égal au rapport de l'intégrale de la variation relative de sa longueur entre la température ambiante et la température de fonctionnement pour le matériau considéré sur cet intervalle de température, supérieur à celui du matériau constitutif du circuit de lecture (7), et supérieur à celui du matériau constitutif du plan froid (5).

8. Détecteur de rayonnements électro-magnétiques, et notamment infrarouges, comprenant :

   - un bloc de détection intégrant au sein d'une enceinte cryostatique :

     . un circuit de détection (8) desdits rayonnements ;
     . un circuit de lecture (7), connecté électriquement et mécaniquement au moyen de microbilles d'indium (9) audit circuit de détection (8) ;

   - un plan froid (5) solidarisé au doigt froid (4) d'un système cryogénérateur,
   - un élément intermédiaire (11, 14) solidarisé au bloc de détection (7, 8, 9) et au plan froid (5),

*caractérisé* en ce que l'élément intermédiaire (11, 14) est pluri-composants et comporte deux plaques parallèles (11, 14), respectivement une plaque supérieure (11), solidarisée au circuit de lecture (7) au moyen d'un joint de colle époxyde (19), et une plaque inférieure (14), solidarisée à ladite plaque supérieure (11) au moyen d'un joint de colle silicone (20), et au plan froid (5) par tout moyen, les matériaux et les épaisseurs desdites plaques (11, 14) étant fonction de celle du circuit de lecture (7), de telle sorte à compenser les effets inhérents aux phénomènes de dilatation différentielle de chacun des matériaux qui les composent.

9. Détecteur de rayonnements électro-magnétiques, et notamment infrarouges selon la revendication 8,

*caractérisé* en ce que la plaque supérieure (11) constitutive de l'élément intermédiaire (11, 14) est réalisé en un matériau présentant un coefficient de dilatation linéaire moyen, défini comme étant égal au rapport de l'intégrale de la variation relative de sa longueur entre la température ambiante et la température de fonctionnement pour le matériau considéré sur cet intervalle de température, supérieur à celui du matériau constitutif du circuit de lecture (7), et supérieur à celui du matériau constitutif de la plaque inférieure (14).

10. Détecteur de rayonnements électro-magnétiques, et notamment infrarouges selon la revendication 9, *caractérisé* en ce que la plaque inférieure (14) constitutive de l'élément intermédiaire (11, 14) est réalisé en un matériau présentant un coefficient de dilatation linéaire moyen voisin de celui du matériau constitutif du circuit de lecture (7).

11. Détecteur de rayonnements électro-magnétiques, et notamment infrarouges selon les revendications 6 à 10, *caractérisé* en ce que l'élément intermédiaire (11, 14, 16) est réalisé en un matériau choisi dans le groupe comprenant l'alumine polycrystalline, le saphir, le nitrure d'aluminium, le silicium passivé, le carbure de silicium.

FIG.1

ART ANTERIEUR

FIG.2

# FIG.3

FIG 4

EP 0 757 234 A1

Office européen
des brevets

**RAPPORT DE RECHERCHE EUROPEENNE**

Numero de la demande
EP 96 42 0256

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| Y | EP-A-0 419 371 (DETECTEURS INFRAROUGES SOFRADI) 27 Mars 1991 * colonne 4, ligne 58 - colonne 6, ligne 7; figure 2 * | 1,2,5,6, 8,11 | G01J5/06 H01L31/024 |
| Y | PATENT ABSTRACTS OF JAPAN vol. 012, no. 265 (E-637), 23 Juillet 1988 & JP-A-63 050046 (TOSHIBA CORP), 2 Mars 1988, | 1,2,5,6, 8,11 | |
| A | * abrégé * | 4,7,9 | |
| A | US-A-4 954 708 (SALZER DONALD E ET AL) 4 Septembre 1990 * colonne 3, ligne 13 - colonne 4, ligne 14; figures 1,2 * | 1-9,11 | |
| A | EP-A-0 464 893 (PHILIPS ELECTRONICS UK LTD ;PHILIPS NV (NL)) 8 Janvier 1992 * colonne 4, ligne 19 - ligne 31; figure 1 * | 5,11 | |
| A | US-A-5 264 699 (BARTON JEFFREY ET AL) 23 Novembre 1993 * colonne 5, ligne 63 - colonne 7, ligne 14; figure 3 * | 1,6,8 | **DOMAINES TECHNIQUES RECHERCHES (Int.Cl.6)** G01J H01L F25D |
| A | EP-A-0 485 312 (SOFRADIR) 13 Mai 1992 * colonne 4, ligne 37 - ligne 50 * | 3,6 | |

Le présent rapport a été établi pour toutes les revendications

| Lieu de la recherche | Date d'achèvement de la recherche | Examinateur |
|---|---|---|
| BERLIN | 8 Octobre 1996 | von Moers, F |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant